# EUROPEAN PATENT SPECIFICATION

(11) **EP 3 059 490 B1**
(45) Date of publication and mention of the grant of the patent: **16.08.2023**
(21) Application number: 16154360.8
(22) Date of filing: 05.02.2016
(51) Int. Cl.: B60Q 1/26, F21S 43/14, F21S 43/19, F21S 43/245, F21S 45/48, H01L 25/075, F21Y 101/00, F21Y 115/10

(54) **VEHICLE LIGHTING DEVICE AND VEHICLE LAMP**
FAHRZEUGBELEUCHTUNGSVORRICHTUNG UND FAHRZEUGLAMPE
DISPOSITIF D'ÉCLAIRAGE DE VÉHICULE ET PHARE DE VÉHICULE

(30) Priority: 23.02.2015 JP 2015033290
(43) Date of publication of application: 24.08.2016
(73) Proprietor: Toshiba Lighting & Technology Corporation, Yokosuka-shi Kanagawa 237-8510 (JP)
(72) Inventor: HATANAKA, Toshihiro, Kanagawa, 237-8510 (JP); KOSUGI, Daisuke, Kanagawa, 237-8510 (JP)
(74) Representative: AWA Sweden AB

(56) References cited:
- WO-A1-2013/153938
- WO-A1-2014/162642
- DE-A1-102005 048 498
- DE-A1-102012 102 301
- DE-U1-202014 002 809
- JP-A- 2013 025 935
- JP-A- 2014 212 073
- US-A1- 2009 296 417

## Description

### Fl ELD

Embodiments described herein relate generally to a vehicle lighting device and a vehicle lamp.

### BACKGROUND

Recently, a vehicle lighting device (for example, a lighting device for automobiles) using a light emitting diode (LED) as a light source has been implemented in place of an incandescent bulb (filament bulb).

In general, the vehicle lighting device emits light of a different color for each function. For example, a vehicle lighting device used for a position lamp emits white light. A vehicle lighting device used for a brake lamp emits red light.

Therefore, a vehicle lighting device including light emitting diodes emitting red light, light emitting diodes emitting yellow light, and light emitting diodes emitting white light, or a vehicle lighting device including light emitting diodes emitting white light and light emitting diodes emitting blue light, which selectively emits light of one of the colors has been proposed.

In this case, the light is emitted from different positions depending on a desired color. For example, the red light is emitted from the light emitting diodes emitting the red light. The white light is emitted from the light emitting diodes emitting the white light.

Therefore, there is a concern that light distribution characteristics of the vehicle lighting device are changed for each color of the light.

Thus, development of a vehicle lighting device and a vehicle lamp, which can selectively emit light of a plurality of colors and can suppress a change in light distribution characteristics, has been desired.

DE 20 2014 002809 U1, US 2009/296417 A1, JP 2014 212073 A and DE 10 2005 048498 A1 disclose examples of prior art lighting devices.

### DESCRI PTI ON OF THE DRAWlNGS

FIG. 1 is a schematic partial sectional view illustrating a vehicle lighting device and a vehicle lamp according to an embodiment of the invention.
FIG. 2 is a schematic perspective view illustrating the vehicle lighting device.
FIG. 3 is a schematic perspective view illustrating a light emitting module.
FIG. 4 is a schematic perspective view illustrating a light emitting portion.
FIG. 5 is a schematic perspective view illustrating a socket.
FIG. 6 is a schematic perspective view illustrating a light emitting module according to another embodiment, which does not make part of the claimed invention.
FIGs. 7A to 7C are schematic views illustrating arrangements of the light emitting portion.
FIG. 8 is a schematic sectional view illustrating an optical element portion according to another embodiment, which does not make part of the claimed invention.

### DETAILED DESCRIPTION

A vehicle lighting device according to an exemplary embodiment includes a flange portion; a storage portion that protrudes from one surface of the flange portion; and a light emitting module that is provided in an end portion of the storage portion on a side opposite to the flange portion side.

The light emitting module includes a substrate, a first light emitting portion that is provided on the substrate, has a light emitting element, and emits white light, a second light emitting portion that is provided on the substrate, has a light emitting element, and emits red or amber light, a control portion that causes one of the first light emitting portion and the second light emitting portion to emit light, and a diffusion portion that has a light-transmitting property and covers the first light emitting portion and the second light emitting portion. The diffusion portion includes a diffusion material that diffuses the light emitted from the first light emitting portion and the second light emitting portion. The first light emitting portion and the second light emitting portion are provided in a position which is shifted from the central axis of the vehicle lighting device and the first light emitting portion and the second light emitting portion are provided in a region of which a diameter is within 20 mm on the substrate.

In the vehicle lighting device, it is possible to selectively emit light of a plurality of colors and to suppress a change in light distribution characteristics.

Furthermore, the first light emitting portion and the second light emitting portion are provided in a region of which a diameter is within 20 mm on the substrate.

That's why it is possible to further suppress the change in the light distribution characteristics.

A vehicle lighting device according to another exemplary embodiment, which does not make part of the claimed invention, includes a flange portion; a storage portion that protrudes from one surface of the flange portion; and a light emitting module that is provided in an end portion of the storage portion on a side opposite to the flange portion side.

The light emitting module includes a substrate, a first light emitting portion that has a light emitting element and emits white light, a second light emitting portion that has a light emitting element and emits red or amber light, a control portion that causes one of the first light emitting portion and the second light emitting portion to emit light, a first envelope that stores the first light emitting portion and is provided in the substrate, and a second envelope that stores the second light emitting portion and is provided in the substrate. The first light emitting portion and the second light emitting portion are provided in a region of which a diameter is within 20 mm on the substrate.

In the vehicle lighting device, it is possible to selectively emit light of a plurality of colors and to suppress a change in light distribution characteristics.

Furthermore, the first light emitting portion may have a first phosphor portion including a first phosphor, and the second light emitting portion may have a second phosphor portion including a second phosphor.

In this case, it is possible to easily generate light of a plurality of colors.

Furthermore, the control portion may further control brightness of light emitted from at least one of the first light emitting portion and the second light emitting portion.

In this case, it is possible to achieve expansion of applications.

A vehicle lamp according to still another exemplary embodiment includes the above-described vehicle lighting device; and an optical element portion on which light emitted from the vehicle lighting device is incident.

According to the vehicle lamp, it is possible to selectively emit light of a plurality of colors and to suppress a change in light distribution characteristics.

Furthermore, the optical element portion may be a light guide body.

In this case, it is possible to achieve expansion of applications.

Hereinafter, exemplary embodiments will be described with reference to the drawings. Moreover, the same reference numerals are given to the same configuration elements in each drawing and detailed description will be appropriately omitted.

As a vehicle lamp 100 of the exemplary embodiment, for example, a front combination light (formed by appropriately combining, for example, a daytime running lamp (DRL; Daylight Running Lamp), a position lamp, a turn signal lamp, and the like), a rear combination light (formed by appropriately combining, for example, a stop lamp, a tail lamp, a turn signal lamp, a back lamp, a fog lamp, and the like), and the like can be exemplified.

Moreover, hereinafter, as an example, a case where the automobile includes the front combination light in which the vehicle lamp 100 is provided in the automobile will be described. However, the vehicle lamp 100 is not limited to the front combination light provided in the automobile. The vehicle lamp 100 is provided in the automobile, a railway vehicle, and the like, and may selectively emit light of a plurality of colors.

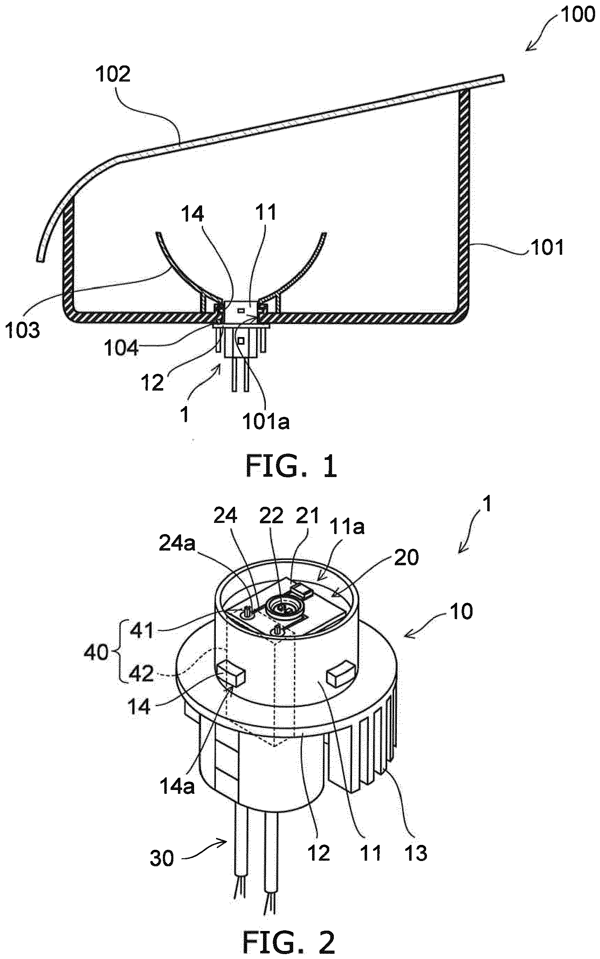

FIG. 1 is a schematic partial sectional view illustrating a vehicle lighting device 1 and the vehicle lamp 100 according to the embodiment.

As illustrated in FIG. 1, the vehicle lighting device 1, a housing 101, a cover 102, an optical element portion 103, and a seal member 104 are provided in the vehicle lamp 100.

The housing 101 has a box shape of which one end portion is opened. The housing 101 can be formed of, for example, resin and the like through which light is not transmitted.

A mounting hole 101a into which a storage portion 11 of the vehicle lighting device 1 is inserted is provided in a bottom surface of the housing 101.

Concave portions, into which convex portions 14 provided in the storage portion 11 are inserted, are provided in a periphery of the mounting hole 101a.

Moreover, a case where the mounting hole 101a is directly provided in the housing 101 is exemplified, but a mounting member having the mounting hole 101a may be provided in the housing 101.

When mounting the vehicle lighting device 1 on the vehicle lamp 100, the storage portion 11 having the convex portions 14 is inserted into the mounting hole 101a and the vehicle lighting device 1 is rotated. Then, the convex portions 14 are held by the concave portions provided on the periphery of the mounting hole 101a.

Such a mounting method is called a twist-lock.

The cover 102 is provided so as to close an opening of the housing 101. The cover 102 can be formed of resin and the like having a light-transmitting property.

The cover 102 can have functions of a lens and the like.

Light emitted from the vehicle lighting device 1 is incident on the optical element portion 103.

The optical element portion 103 performs reflection, diffusion, guiding, and condensing of the light emitted from the vehicle lighting device 1, formation of a predetermined light distribution pattern, and the like.

For example, the optical element portion 103 illustrated in FIG. 1 is a reflector, reflects the light emitted from the vehicle lighting device 1, and causes the predetermined light distribution pattern to be formed.

If the optical element portion 103 is the reflector, the optical element portion 103 is on the inside of the housing 101 and can be provided coaxially with a central axis of the mounting hole 101a.

The seal member 104 is provided between a flange portion 12 and the housing 101.

The seal member 104 can be formed of a material having elasticity such as rubber or silicone resin.

When mounting the vehicle lighting device 1 on the vehicle lamp 100, the seal member 104 is interposed between the flange portion 12 and the housing 101. Thus, an interior space of the housing 101 is closed by the seal member 104.

In addition, the convex portions 14 are pressed against the housing 101 by elastic force of the seal member 104. Thus, the vehicle lighting device 1 can be suppressed to be separated from the housing 101.

FIG. 2 is a schematic perspective view illustrating the vehicle lighting device 1.

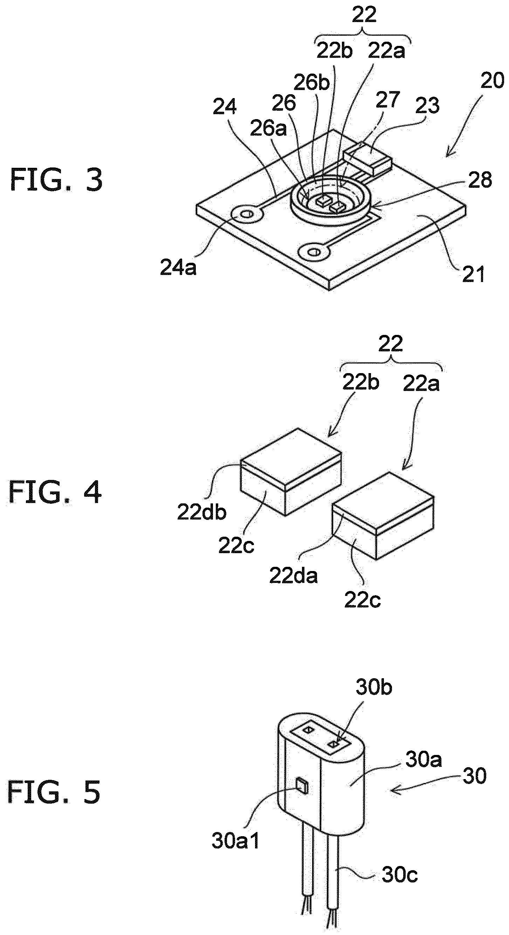

FIG. 3 is a schematic perspective view illustrating a light emitting module 20.

As illustrated in FIG. 2, a body portion 10, a light emitting module 20, a socket 30, and a power supply portion 40 are provided in the vehicle lighting device 1.

As illustrated in FIG. 2, the storage portion 11, the flange portion 12, fins 13, and the convex portions 14 are provided in the body portion 10.

An appearance of the storage portion 11 has a cylindrical shape and the storage portion 11 protrudes from one surface of the flange portion 12. A concave portion 11a is provided in an end portion of the storage portion 11 on a side opposite to the flange portion 12 side.

A substrate 21 is provided on a bottom surface of the concave portion 11a. A surface of the substrate 21 on a side opposite to a side on which a light emitting portion 22 is provided comes into contact with the bottom surface of the concave portion 11a.

That is, the light emitting module 20 is provided in the end portion of the storage portion 11 on a side opposite to a flange portion 12 side.

In addition, a plurality of power supply terminals 41 protrude from the bottom surface of the concave portion 11a. The plurality of the power supply terminals 41 do not come into contact with the bottom surface of the concave portion 11a.

The flange portion 12 has a disc shape, the storage portion 11 is provided on one surface, and the fins 13 are provided on the other surface.

A plurality of the fins 13 are provided to protrude from the surface of the flange portion 12. The plurality of the fins 13 have a plate shape and function as radiating fins.

The convex portion 14 is provided in a side wall of the storage portion 11. The convex portion 14 protrudes outward from the side wall of the storage portion 11.

The number and arrangement position of the convex portions 14 are not specifically limited.

In this case, if the plurality of the convex portions 14 are provided, it is possible to stabilize holding of the vehicle lighting device 1.

In order to stabilize holding of the vehicle lighting device 1, it is preferable that three or more convex portions 14 are provided. In the case of FIG. 2, four convex portions 14 are provided.

Here, the body portion 10 has a function of storing the light emitting module 20 and a function of radiating heat generated in the light emitting module 20 to the outside of the vehicle lighting device 1.

Therefore, it is preferable that the body portion 10 is formed of a material having high thermal conductivity in consideration of releasing heat to the outside.

The body portion 10 can be formed, for example, of metal such as aluminum or resin having high thermal conductivity.

The resin having high thermal conductivity is obtained by mixing, for example, fibers or particles made of carbon having high thermal conductivity and the like with resin such as polyethylene terephthalate (PET) or nylon.

It is preferable that the vehicle lighting device 1 is made to be light-weight.

Therefore, it is preferable that the body portion 10 is formed of resin having high thermal conductivity.

In addition, the storage portion 11, the flange portion 12, the fins 13, and the convex portions 14 can be integrally formed.

Moreover, the storage portion 11, the flange portion 12, the fins 13, and the convex portions 14 are separately formed, and can be bonded together. If the storage portion 11, the flange portion 12, the fins 13, and the convex portions 14 are separately formed, these members can be formed of the same material or can be formed of different materials.

As illustrated in FIG. 3, the substrate 21, a wiring pattern 24, the light emitting portion 22, a control portion 23, a frame portion 26, a diffusion portion 27, and a bonding portion 28 are provided in the light emitting module 20.

The substrate 21 has a plate shape and the wiring pattern 24 is provided on a surface thereof.

A material or a structure of the substrate 21 is not specifically limited. For example, the substrate 21 can be formed of an inorganic material (ceramics) such as aluminum oxide or aluminum nitride, an organic material such as paper phenol or glass epoxy, and the like. In addition, the substrate 21 can be formed by coating a surface of a metal plate with an insulating material. Moreover, in a case of coating the surface of the metal plate with the insulating material, the insulating material may be formed of an organic material or may be formed of an inorganic material.

If a heating value of the light emitting portion 22 is large, it is preferable that the substrate 21 is formed by using a material having high thermal conductivity in terms of heat radiation. As the material having high thermal conductivity, ceramics such as aluminum oxide or aluminum nitride, a material that is obtained by coating a surface of a metal plate with an insulating material, and the like can be exemplified.

In addition, the substrate 21 may be a single layer or may be a multi-layer.

The wiring pattern 24 is provided on at least one surface of the substrate 21.

The wiring pattern 24 can be provided on both surfaces of the substrate 21, but in order to reduce manufacturing costs, it is preferable that the wiring pattern 24 is provided on one surface of the substrate 21.

An input terminal 24a is provided in the wiring pattern 24.

A plurality of the input terminals 24a are provided. The power supply terminal 41 is electrically connected to the input terminal 24a.

The light emitting portion 22 is mounted on the wiring pattern 24 provided on the surface of the substrate 21 using a Chip on Board (COB) method.

Therefore, the light emitting portion 22 is electrically connected to the power supply terminal 41 via the wiring pattern 24.

The light emitting portion 22 can have electrodes (not illustrated) on a surface (upper surface) on a side opposite to a side on which the wiring pattern 24 is provided. The electrodes (not illustrated) may be provided on a surface (lower surface) on the side on which the wiring pattern 24 is provided and the surface (upper surface) on the side opposite to the side on which the wiring pattern 24 is provided, or may be provided only on either side.

The electrodes (not illustrated) provided on the lower surface of the light emitting portion 22 are electrically connected to a mounting pad provided in the wiring pattern 24 via a conductive thermoset material such as silver paste. The electrodes (not illustrated) provided on the upper surface of the light emitting portion 22 are electrically connected to a wiring pad provided in the wiring pattern 24 via wiring.

The light emitting portion 22 can have a first light emitting portion 22a that emits, for example, light of a first color and a second light emitting portion 22b that emits light of a second color different from the first color.

FIG. 4 is a schematic perspective view illustrating the light emitting portion 22.

The first light emitting portion 22a has a light emitting element 22c and a phosphor portion 22da (corresponding to an example of a first phosphor portion) that is provided on a light emitting surface of the light emitting element 22c.

The second light emitting portion 22b has a light emitting element 22c and a phosphor portion 22db (corresponding to an example of a second phosphor portion) that is provided on a light emitting surface of the light emitting element 22c.

The light emitting element 22c can be, for example, a light emitting diode, an organic light emitting diode, a laser diode, and the like.

The phosphor portions 22da and 22db include phosphor (corresponding to an example of a first phosphor or a second phosphor) that is excited by light emitted from the light emitting elements 22c and emits fluorescence.

The phosphor portions 22da and 22db can be, for example, a tape including phosphor. In this case, the tape-shaped phosphor portions 22da and 22db are bonded to the light emitting surface of the light emitting element 22c.

The color of the light can be controlled by a type of the phosphor, and a content of the phosphor included in the phosphor portions 22da and 22db.

For example, if the first light emitting portion 22a emits the white light, the light emitting element 22c is a blue light emitting diode and the phosphor portion 22da can include phosphor emitting yellow fluorescence.

In this case, the white light is emitted from the first light emitting portion 22a by mixing the blue light emitted from the light emitting element 22c and the yellow light emitted from the phosphor.

Moreover, a ratio of the blue light and the yellow light can be controlled by an amount of the phosphor.

For example, if most of the blue light emitted from the light emitting element 22c is converted into the yellow light by increasing the amount of the phosphor emitting yellow fluorescence, it is possible to emit the yellow light from the first light emitting portion 22a.

For example, if the second light emitting portion 22b emits red or amber light, the light emitting element 22c is the blue light emitting diode and the phosphor portion 22db can include phosphor emitting red fluorescence or can include phosphor emitting red fluorescence, phosphor emitting yellow fluorescence, and the like.

In this case, it is possible to emit the red light or the amber light from the second light emitting portion 22b by converting most of the blue light emitted from the light emitting element 22c into the red light or the amber light.

Moreover, a case where the color of the light is changed by using the phosphor is exemplified, but it is possible to only use the light emitting element 22c emitting a desired color.

For example, it is possible to use a light emitting diode emitting the red light, a light emitting diode emitting the yellow green light, a light emitting diode emitting the blue light, a light emitting diode emitting green light, and the like as it is.

In addition, types of the color of the light are not limited to two types. The types of the color of the light may be two types or more. The type or the number of the color of the light can be appropriately changed depending on usage of the vehicle lighting device 1 and the like.

For example, the white light is used for a daytime running lamp, a position lamp, a back lamp, and the like.

The red light is used for a stop lamp, a tail lamp, and the like.

The amber light is used for a turn signal lamp and the like.

The yellow light is used for a fog lamp and the like.

In addition, various colors of the light are used in lamps for decoration.

In addition, the number, a size, and arrangement of the light emitting portions 22, and the like are not limited to the example and can be appropriately changed depending on the size and the usage of the vehicle lighting device 1, and the like.

The control portion 23 is mounted on the wiring pattern 24.

The control portion 23 causes one of the first light emitting portion 22a and the second light emitting portion 22b to emit light. In this case, if light is emitted from the first light emitting portion 22a, the control portion 23 causes the second light emitting portion 22b not to emit light. If light is emitted from the second light emitting portion 22b, the control portion 23 causes the first light emitting portion 22a not to emit light.

In addition, the control portion 23 controls brightness of light emitted from the first light emitting portion 22a and the second light emitting portion 22b respectively.

For example, if the first light emitting portion 22a emits the white light, it is possible to use the first light emitting portion 22a as the daytime running lamp or the position lamp. If the first light emitting portion 22a is used as the daytime running lamp, the control portion 23 controls light flux of the light emitted from the first light emitting portion 22a to be approximately 300 lumens. If the first light emitting portion 22a is used as the position lamp, the control portion 23 controls the light flux of the light emitted from the first light emitting portion 22a to be approximately 50 lumens.

If the second light emitting portion 22b emits the red light, the second light emitting portion 22b can be used as the stop lamp or the tail lamp. If the second light emitting portion 22b is used as the stop lamp, the control portion 23 controls the light flux of the light emitted from the second light emitting portion 22b to be approximately 100 lumens. If the second light emitting portion 22b is used as the tail lamp, the control portion 23 controls the light flux of the light emitted from the second light emitting portion 22b to be approximately 10 lumens.

Thus, it is possible to achieve expansion of applications.

Moreover, the number of switching of the brightness or a degree of the brightness is not limited to the example.

In addition, it is possible to provide a film-like resistor (not illustrated) for controlling a value of a current flowing through the light emitting element 22c such that the brightness of the light emitted from the light emitting element 22c is within a predetermined range. It is possible to provide a diode (not illustrated) such that a reverse voltage is not applied to the light emitting element 22c and pulse noise from a reverse direction is not applied to the light emitting element 22c.

In addition, it is possible to appropriately provide desired circuit components as required.

The frame portion 26 is provided on the substrate 21 so as to surround the first light emitting portion 22a and the second light emitting portion 22b. The frame portion 26 has, for example, an annular shape and the first light emitting portion 22a and the second light emitting portion 22b are disposed in a center portion 26a.

The frame portion 26 can be formed of, for example, resin such as polybutylene terephthalate (PBT) or polycarbonate (PC), ceramics, or the like.

In addition, if the material of the frame portion 26 is resin, it is possible to improve reflectivity with respect to the light emitted from the first light emitting portion 22a and the second light emitting portion 22b by mixing particles consisting of titanium oxide and the like with the resin.

Moreover, the particles are not limited to the particles of titanium oxide and particles consisting of a material having high reflectivity with respect to the light emitted from the first light emitting portion 22a and the second light emitting portion 22b may be mixed.

In addition, the frame portion 26 can be formed of, for example, white resin.

A side wall surface 26b on the center portion 26a side of the frame portion 26 has an inclined surface. Some of the light emitted from the first light emitting portion 22a and the second light emitting portion 22b is reflected on the side wall surface 26b of the frame portion 26 and is emitted toward a front side of the vehicle lighting device 1.

In addition, light, which is some of the light emitted from the first light emitting portion 22a and the second light emitting portion 22b toward the front side of the vehicle lighting device 1 and is total reflected on an upper surface (interface between the diffusion portion 27 and outside air) of the diffusion portion 27, is reflected on the side wall surface 26b on the center portion 26a side of the frame portion 26 and is emitted again toward the front side of the vehicle lighting device 1.

That is, the frame portion 26 can also have a function of a reflector. Moreover, a form of the frame portion 26 is not limited to the example and can be appropriately changed.

The diffusion portion 27 is provided in the center portion 26a of the frame portion 26. The diffusion portion 27 is provided to cover the inside of the frame portion 26. That is, the diffusion portion 27 is provided on the inside of the frame portion 26 and covers the first light emitting portion 22a and the second light emitting portion 22b.

The diffusion portion 27 has the light-transmitting property. The diffusion portion 27 is formed of a material having the light-transmitting property. The diffusion portion 27 can be formed of, for example, silicone resin and the like.

The diffusion portion 27 can be formed by, for example, filling the center portion 26a of the frame portion 26 with resin. Filling with resin can be performed by using a liquid dispensing device such as a dispenser.

In addition, the diffusion portion 27 further includes a diffusion material that diffuses the light emitted from the first light emitting portion 22a and the second light emitting portion 22b.

The diffusion material can be, for example, particles and fibers made of titanium oxide, and the like.

Here, if the diffusion portion 27 would not be provided, the light emitted from the first light emitting portion 22a would mainly be applied to the front side of the first light emitting portion 22a.

The light emitted from the second light emitting portion 22b would mainly be applied to the front side of the second light emitting portion 22b.

As illustrated in FIG. 2, the first light emitting portion 22a and the second light emitting portion 22b are provided in a position which is shifted from the central axis of the vehicle lighting device 1.

Therefore, the light of the first color emitted from the first light emitting portion 22a and the light of the second color emitted from the second light emitting portion 22b are respectively applied to the positions which are shifted from the central axis of the vehicle lighting device 1 and are different from each other.

As a result, there is a concern that the light distribution characteristics of the vehicle lighting device 1 are changed for each color.

In the vehicle lighting device 1 according to the embodiment, since the diffusion portion 27 covering both the first light emitting portion 22a and the second light emitting portion 22b is provided, for both the light emitted from the first light emitting portion 22a and the light emitted from the second light emitting portion 22b, similar diffusion is generated on the inside of the diffusion portion 27.

Thus, both the light emitted from the first light emitting portion 22a and the light emitted from the second light emitting portion 22b are substantially uniformly emitted from the surface of the diffusion portion 27.

As a result, it is possible to suppress that the light distribution characteristics of the vehicle lighting device 1 are changed for each color.

In addition, the diffusion portion 27 covers the first light emitting portion 22a, the second light emitting portion 22b, the wiring pattern 24 disposed in the center portion 26a of the frame portion 26, and the like.

Therefore, it is possible to suppress that external force, gas including moisture and sulfur, and the like, which are contained in an environment in which the vehicle lighting device 1 is provided, come into contact with the first light emitting portion 22a, the second light emitting portion 22b, the wiring pattern 24 disposed in the center portion 26a of the frame portion 26, and the like. As a result, it is possible to improve reliability with respect to the vehicle lighting device 1. In addition, it is possible to suppress that silver and sulfur contained in the wiring pattern 24 are reacted.

The bonding portion 28 bonds the frame portion 26 and the substrate 21.

The bonding portion 28 has a film-like member and is provided between the frame portion 26 and the substrate 21.

The bonding portion 28 can be formed, for example, by curing silicone-based adhesive or epoxy-based adhesive.

FIG. 5 is a schematic perspective view illustrating the socket 30.

As illustrated in FIG. 5, a body portion 30a, a female terminal 30b, and wiring 30c are provided in the socket 30.

The body portion 30a is formed of an insulating material such as resin. A protrusion portion 30a1 is provided on a side wall of the body portion 30a. The socket 30 is held on the body portion 10 by fitting the protrusion portion 30a1 into a concave portion provided in the body portion 10.

The female terminal 30b extends on the inside of the body portion 30a.

One end portion of the female terminal 30b is exposed on one end surface of the body portion 30a. The power supply terminal 41 is fitted into the end portion of the female terminal 30b exposed on one end surface of the body portion 30a.

The wiring 30c is electrically connected to the other end portion of the female terminal 30b.

A power supply (not illustrated) and the like are electrically connected to the wiring 30c.

Therefore, the power supply (not illustrated) and the like are electrically connected to the light emitting portion 22 by fitting the socket 30 into the power supply terminal 41.

The socket 30 can be bonded to an element on a body portion 10 side, for example, by using adhesive and the like.

As illustrated in FIG. 2, the power supply terminal 41 and a holding portion 42 are provided in the power supply portion 40.

A plurality of the power supply terminals 41 are provided.

The power supply terminal 41 has a wire-like member and is formed of a conductive material such as metal.

The plurality of the power supply terminals 41 extend by passing through the holding portion 42.

The power supply terminal 41 protruding from one end portion of the holding portion 42 protrudes from a bottom surface of the concave portion 11a and is electrically connected to the input terminal 24a.

The power supply terminal 41 protruding from the other end portion of the holding portion 42 is fitted into the female terminal 30b.

Moreover, two power supply terminals 41 are exemplified, but the number and a shape of the power supply terminals 41, and the like are not limited to the example, and can be appropriately changed.

As described above, it is preferable that the body portion 10 is formed of resin having high thermal conductivity, metal, and the like.

In this case, the resin having high thermal conductivity is obtained by mixing a material having conductivity such as carbon with resin. Thus, the resin having high thermal conductivity has conductivity.

In a case of the body portion 10 that is made of the resin having high thermal conductivity having conductivity or metal, if the body portion 10 comes into contact with the power supply terminal 41, a short circuit occurs.

Thus, the holding portion 42, which is formed of a material having an insulating property, is provided between the body portion 10 and the power supply terminal 41.

In addition, the holding portion 42 is provided on the inside of a hole provided in the body portion 10.

Here, in a case of the vehicle lighting device 1 provided in an automobile, a temperature of an environment of use is -40°C to 85°C. Thus, it is preferable that a linear expansion coefficient of resin having high thermal conductivity that is a material of the body portion 10 and a linear expansion coefficient of resin that is a material of the holding portion 42 become a value as close as possible. Thus, even if the vehicle lighting device 1 is used in an environment in which a temperature change is great, it is possible to reduce thermal stress generated between the body portion 10 and the holding portion 42.

In this case, it is possible to form the holding portion 42 by using resin contained in the resin having high thermal conductivity.

For example, if the resin having high thermal conductivity obtained by mixing fibers or particles formed of carbon into PET, it is possible to form the holding portion 42 by using PET.

Next, a light emitting module 120 according to another embodiment, which does not make part of the claimed invention, will be described.

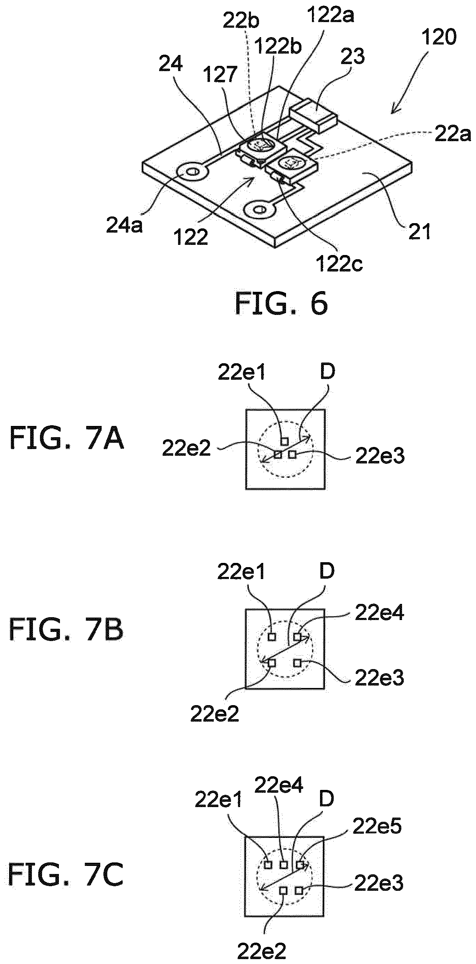

FIG. 6 is a schematic perspective view illustrating the light emitting module 120 according to this embodiment.

In the light emitting module 20 described above, the light emitting portion 22 is mounted on the wiring pattern 24 using the COB method.

On the other hand, in the light emitting module 120, a plastic leaded chip carrier (PLCC) type light emitting portion 122 is mounted on a wiring pattern 24.

As illustrated in FIG. 6, a substrate 21, the wiring pattern 24, the light emitting portion 122, a control portion 23, and a sealing portion 127 are provided in the light emitting module 120.

The light emitting portion 122 has the first light emitting portion 22a that emits the light of the first color and the second light emitting portion 22b that emits the light of the second color different from the first color described above.

The first light emitting portion 22a is provided on an inside of a concave portion 122b provided in an envelope 122a (corresponding to an example of the first envelope). The first light emitting portion 22a is electrically connected to a lead 122c exposed on the inside of the concave portion 122b.

The second light emitting portion 22b is provided on the inside of the concave portion 122b provided in the envelope 122a (corresponding to an example of the second envelope). The second light emitting portion 22b is electrically connected to the lead 122c exposed on the inside of the concave portion 122b.

The envelope 122a can be formed of, for example, resin such as PBT or PC, ceramic, and the like.

In addition, if a material of the envelope 122a is resin, it is possible to improve reflectivity with respect to the light emitted from the first light emitting portion 22a and the second light emitting portion 22b by mixing particles such as titanium oxide with the resin.

Moreover, it is not limited to the particles of titanium oxide and particles, which are formed of a material having high reflectivity with respect to the light emitted from the first light emitting portion 22a and the second light emitting portion 22b, may be mixed with the resin.

In addition, the envelope 122a can be formed of, for example, white resin.

A side wall of the concave portion 122b of the envelope 122a is an inclined surface. Some of the light emitted from the first light emitting portion 22a and the second light emitting portion 22b is reflected on the side wall of the concave portion 122b and is emitted toward a front side of the vehicle lighting device 1.

In addition, light, which is some of the light emitted from the first light emitting portion 22a and the second light emitting portion 22b toward the front side of the vehicle lighting device 1 and is totally reflected on an upper surface (interface between the sealing portion 127 and outside air) of the sealing portion 127, is reflected on the side wall of the concave portion 122b and is emitted again toward the front side of the vehicle lighting device 1.

That is, the envelope 122a can also have a function of a reflector. Moreover, a form of the envelope 122a is not limited to the example and can be appropriately changed.

One end portion of the lead 122c is exposed on the inside of the concave portion 122b.

The other end portion of the lead 122c is bent toward a surface (lower surface) on a side opposite to a side on which the concave portion 122b of the envelope 122a is opened. The lead 122c can be, for example, a J-bend type lead.

A portion of the lead 122c, which is exposed on the inside of the concave portion 122b, is electrically connected to the first light emitting portion 22a and the second light emitting portion 22b.

A portion of the lead 122c, which is bent toward the lower surface of the envelope 122a, is electrically connected to the wiring pattern 24.

Therefore, the first light emitting portion 22a and the second light emitting portion 22b are electrically connected to the wiring pattern 24 via the lead 122c.

The sealing portion 127 is provided on the inside of the concave portion 122b of the envelope 122a. The sealing portion 127 is provided to cover the inside of the concave portion 122b. That is, the sealing portion 127 is provided on the inside of the concave portion 122b and covers the first light emitting portion 22a, the second light emitting portion 22b, and one end portion of the lead 122c.

The sealing portion 127 is formed of a material having the light-transmitting property. The sealing portion 127 can be formed of, for example, silicone resin and the like.

The sealing portion 127 can be formed by, for example, filling the concave portion 122b of the envelope 122a with resin. Filling with resin can be performed by using a liquid dispensing device such as a dispenser.

If the concave portion 122b of the envelope 122a is filled with resin, it is possible to suppress mechanical contact of the first light emitting portion 22a, the second light emitting portion 22b, and the like from the outside. In addition, it is possible to suppress that gas, moisture, and the like are adhered to the first light emitting portion 22a, the second light emitting portion 22b, and the like. Thus, it is possible to improve reliability with respect to the vehicle lighting device 1.

It is also possible to impart the functions of the phosphor portion 22da and the phosphor portion 22db to the sealing portion 127.

For example, only the light emitting element 22c is provided on the inside of the concave portion 122b of the envelope 122a in place of the first light emitting portion 22a and the phosphor included in the phosphor portion 22da can be included in the sealing portion 127.

In addition, only the light emitting element 22c is provided on the inside of the concave portion 122b of the envelope 122a in place of the second light emitting portion 22b and the phosphor included in the phosphor portion 22db can be included in the sealing portion 127.

Here, the sealing portion 127 covers one of the first light emitting portion 22a and the second light emitting portion 22b. Thus, the light emitted from the first light emitting portion 22a and the second light emitting portion 22b is not introduced into the inside of one sealing portion 127 different from the diffusion portion 27 described above.

In this case, the light emitted from the first light emitting portion 22a is mainly applied to the front side of the first light emitting portion 22a via the sealing portion 127.

The light emitted from the second light emitting portion 22b is mainly applied to the front side of the second light emitting portion 22b via the sealing portion 127.

Therefore, the light of the first color emitted from the first light emitting portion 22a and the light of the second color emitted from the second light emitting portion 22b are respectively applied to the positions which are shifted from the central axis of the vehicle lighting device 1 and are different from each other.

As a result, there is a concern that the light distribution characteristics of the vehicle lighting device 1 are changed for each color.

However, the first light emitting portion 22a and the second light emitting portion 22b are provided on the inside of the envelope 122a. Thus, it is possible to suppress that heat generated by one of the first light emitting portion 22a and the second light emitting portion 22b is transmitted to the other side.

Thus, it is possible to reduce a distance between the first light emitting portion 22a and the second light emitting portion 22b.

If the distance between the first light emitting portion 22a and the second light emitting portion 22b is reduced, it is possible to suppress that the light distribution characteristics of the vehicle lighting device 1 are changed for each color.

According to findings obtained by the inventors, if the first light emitting portion 22a and the second light emitting portion 22b are provided in a region of which a diameter is equal to or less than 20 mm, and particularly preferably in a region of which a diameter is equal to or less than 10 mm, it is possible to suppress that the light distribution characteristics of the vehicle lighting device 1 are changed for each color.

Moreover, even in a case where the diffusion portion 27 described above is provided, it is preferable that the first light emitting portion 22a and the second light emitting portion 22b are provided in the region of which the diameter is equal to or less than 20 mm, and particularly preferably in the region of which the diameter is equal to or less than 10 mm.

Next, arrangement of the light emitting portion will be further described.

FIGs. 7A to 7C are schematic views illustrating arrangements of the light emitting portion.

Light emitting portions 22e1 to 22e5 can respectively emit different colors and a part of the light emitting portions 22e1 to 22e5 can emit light of the same color.

The number and arrangement shape of the light emitting portions are not particularly limited and it is preferable that the light emitting portions are provided in a region of which a diameter D is equal to or less than 20 mm, and particularly preferably in a region of which a diameter D is equal to or less than 10 mm.

If all the light emitting portions are provided in the region of which the diameter D is equal to or less than 20 mm and particularly preferably in the region of which the diameter D is equal to or less than 10 mm, it is possible to suppress that the light distribution characteristics of the vehicle lighting device 1 are changed for each color.

Next, an optical element portion will be described.

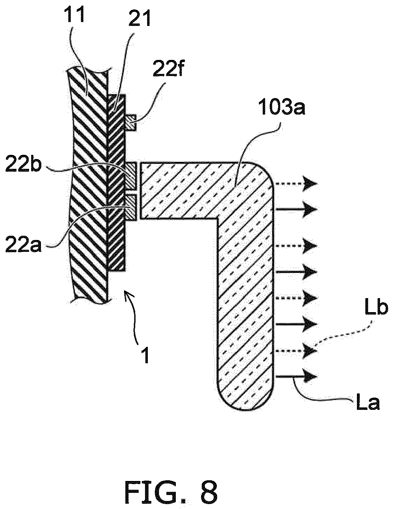

FIG. 8 is a schematic sectional view illustrating an optical element portion 103a according to another embodiment. As described above, the optical element portion performs reflection, diffusion, guiding, and condensing of the light emitted from the vehicle lighting device 1, formation of a predetermined light distribution pattern, and the like.

For example, the optical element portion 103 illustrated in FIG. 1 is the reflector and the predetermined light distribution pattern is formed by reflecting the light emitted from the vehicle lighting device 1.

The optical element portion 103a illustrated in FIG. 8 is a light guide body (light guide), guides the light emitted from the vehicle lighting device 1, and applies the guided light to a desired position or region.

The optical element portion 103a is formed of a material having the light-transmitting property such as transparent resin or glass.

Light La emitted from the light emitting portion 22a propagates through the inside of the optical element portion 103a and is applied from a predetermined region of the optical element portion 103a.

Light Lb emitted from the light emitting portion 22b propagates through the inside of the optical element portion 103a and is applied from a predetermined region of the optical element portion 103a.

If the optical element portion 103a is the light guide body, the optical element portion 103a has the same diffusion operation as the diffusion portion 27 described above. Thus, if the optical element portion 103a is the light guide body, the diffusion portion 27 is not necessarily required. The embodiment illustrated in Fig. 8 does not fall within the claimed invention.

In addition, the optical element portion can be provided in at least one of a plurality of the light emitting portions.

For example, as illustrated in FIG. 8, the optical element portion 103a is provided in the light emitting portions 22a and 22b, and the optical element portion 103a cannot be provided in a light emitting portion 22f.

In addition, a plurality of the optical element portions having different functions are provided or a plurality of the optical element portions having the same function may be provided.

While certain embodiments have been described, these embodiments have been presented by way of example only, and are not intended to limit the scope of the invention. The scope of the invention is limited only by the appended claims.

## Claims

1. A vehicle lighting device (1) comprising:
a flange portion (12);
a storage portion (11) that protrudes from one surface of the flange portion (12); and
a light emitting module (20) that is provided in an end portion of the storage portion (11) on a side opposite to the flange portion (12) side,
the light emitting module (20) including
a substrate (21),
a first light emitting portion (22a) that is provided on the substrate (21), has a light emitting element (22c), and emits white light,
a second light emitting portion (22b) that is provided on the substrate (21), has a light emitting element (22c), and emits red or-amber light,
a control portion (23) that causes one of the first light emitting portion (22a) and the second light emitting portion (22b) to emit light, and
a portion (27) that has a light-transmitting property and covers the first light emitting portion (22a) and the second light emitting portion (22b),
**characterized in that**
the portion (27) is a diffusion portion (27) and the diffusion portion (27) includes a diffusion material that diffuses the light emitted from the first light emitting portion (22a) and the second light emitting portion (22b),
the first light emitting portion (22a) and the second light emitting portion (22b) are provided in a position which is shifted from the central axis of the vehicle lighting device (1), and
the first light emitting portion (22a) and the second light emitting portion (22b) are provided in a region of which a diameter is within 20 mm on the substrate (21).

2. The device (1) according to claim 1, the diffusion material is at least one of particles and fibers made of titanium oxide.

3. The device (1) according to any of the claims 1 to 2,
wherein the first light emitting portion (22a) and the second light emitting portion (22b) are provided in a region of which a diameter is within 10 mm on the substrate (21).

4. The device (1) according to any one of claims 1 to 3
wherein the first light emitting portion (22a) has a first phosphor portion (22da) including a first phosphor, and
the second light emitting portion (22b) has a second phosphor portion (22db) including a second phosphor.

5. The device (1) according to any one of claims 1 to 4,
wherein the control portion (23) further controls brightness of the light emitted from at least one of the first light emitting portion (22a) and the second light emitting portion (22b).

6. A vehicle lamp (100) comprising:
the vehicle lighting device (1) according to any one of claims 1 to 5; and
an optical element portion (103) on which light emitted from the vehicle lighting device (1) is incident.

7. The lamp (100) according to claim 6,
wherein the optical element portion (103) is a light guide body (103a).

## Patentansprüche

1. Fahrzeugbeleuchtungsvorrichtung (1), umfassend:
einen Flanschabschnitt (12);
einen Aufnahmeabschnitt (11), der von einer Fläche des Flanschabschnitts (12) hervorsteht; und
ein lichtemittierendes Modul (20), das in einem Endabschnitt des Aufnahmeabschnitts (11) auf einer dem Flanschabschnitt (12) gegenüberliegenden Seite vorgesehen ist, wobei das lichtemittierende Modul (20) aufweist
ein Substrat (21),
einen ersten lichtemittierenden Abschnitt (22a), der auf dem Substrat (21) vorgesehen ist, ein lichtemittierendes Element (22c) aufweist, und weißes Licht emittiert,
einen zweiten lichtemittierenden Abschnitt (22b), der auf dem Substrat (21) vorgesehen ist, ein lichtemittierendes Element (22c) aufweist, und rotes oder bernsteinfarbenes Licht emittiert,
einen Steuerabschnitt (23), der bewirkt, dass entweder der erste lichtemittierende Abschnitt (22a) oder der zweite lichtemittierende Abschnitt (22b) Licht emittiert, und
einen Abschnitt (27), der eine lichtdurchlässige Eigenschaft aufweist und den ersten lichtemittierenden Abschnitt (22a) und den zweiten lichtemittierenden Abschnitt (22b) abdeckt,
**dadurch gekennzeichnet, dass**
der Abschnitt (27) ein Diffusionsabschnitt (27) ist und der Diffusionsabschnitt (27) Diffusionsmaterial aufweist, das das von dem ersten lichtemittierenden Abschnitt (22a) und dem zweiten lichtemittierenden Abschnitt (22b) emittierte Licht streut,
der erste lichtemittierende Abschnitt (22a) und der zweite lichtemittierende Abschnitt (22b) an einer Position vorgesehen sind, die von der Mittelachse der Fahrzeugbeleuchtungsvorrichtung (1) verschoben ist, und
der erste lichtemittierende Abschnitt (22a) und der zweite lichtemittierende Abschnitt (22b) auf dem Substrat (21) in einem Bereich vorgesehen sind, dessen Durchmesser innerhalb von 20 mm liegt.

2. Vorrichtung (1) nach Anspruch 1, wobei das Diffusionsmaterial mindestens eines von Partikeln und Fasern aus Titanoxid ist.

3. Vorrichtung (1) nach einem der Ansprüche 1 bis 2,
wobei der erste lichtemittierende Abschnitt (22a) und der zweite lichtemittierende Abschnitt (22b) auf dem Substrat (21) in einem Bereich vorgesehen sind, dessen Durchmesser innerhalb von 10 mm liegt.

4. Vorrichtung (1) nach einem der Ansprüche 1 bis 3,
wobei der erste lichtemittierende Abschnitt (22a) einen ersten Leuchtstoffabschnitt (22da) aufweist, der einen ersten Leuchtstoff aufweist, und
der zweite lichtemittierende Abschnitt (22b) einen zweiten Leuchtstoffabschnitt (22db) aufweist, der einen zweiten Leuchtstoff aufweist.

5. Vorrichtung (1) nach einem der Ansprüche 1 bis 4,
wobei der Steuerabschnitt (23) ferner die Helligkeit des von mindestens einem von dem ersten lichtemittierenden Abschnitt (22a) und dem zweiten lichtemittierenden Abschnitt (22b) emittierten Licht steuert.

6. Fahrzeuglampe (100), umfassend:
die Fahrzeugbeleuchtungsvorrichtung (1) nach einem der Ansprüche 1 bis 5; und
einen optischen Elementabschnitt (103), auf den von der Fahrzeugbeleuchtungsvorrichtung (1) emittiertes Licht einfällt.

7. Lampe (100) nach Anspruch 6,
wobei der optische Elementabschnitt (103) ein Lichtleiterkörper (103a) ist.

## Revendications

1. Dispositif d'éclairage de véhicule (1) comprenant :
une partie de bride (12) ;
une partie de stockage (11) qui dépasse d'une surface de la partie de bride (12) ; et
un module d'émission de lumière (20) qui est prévu dans une partie d'extrémité de la partie de stockage (11) sur un côté opposé au côté de la partie de bride (12), le module d'émission de lumière (20) comprenant
un substrat (21),
une première partie électroluminescente (22a) qui est disposée sur le substrat (21), comporte un élément électroluminescent (22c) et émet de la lumière blanche,
une deuxième partie électroluminescente (22b) qui est prévue sur le substrat (21), comporte un élément électroluminescent (22c) et émet une lumière rouge ou ambrée,
une partie de commande (23) qui amène une parmi la première partie électroluminescente (22a) et la deuxième partie électroluminescente (22b) à émettre de la lumière, et
une partie (27) qui a une propriété de transmission de la lumière et recouvre la première partie d'émission de lumière (22a) et la deuxième partie d'émission de lumière (22b),
**caractérisé en ce que**
la partie (27) est une partie de diffusion (27) et la partie de diffusion (27) comprend un matériau de diffusion qui diffuse la lumière émise par la première partie électroluminescente (22a) et la deuxième partie électroluminescente (22b), la première partie électroluminescente (22a) et la deuxième partie électroluminescente (22b) sont prévues dans une position qui est décalée de l'axe central du dispositif d'éclairage de véhicule (1), et la première partie électroluminescente(22a) et la deuxième partie électroluminescente (22b) est prévue dans une région dont un diamètre est inférieur à 20 mm sur le substrat (21).

2. Dispositif (1) selon la revendication 1, le matériau de diffusion est au moins un parmi des particules et des fibres en oxyde de titane.

3. Dispositif (1) selon une quelconque des revendications 1 à 2, dans lequel la première partie électroluminescente (22a) et la deuxième partie électroluminescente (22b) sont prévues dans une région dont un diamètre est inférieur à 10 mm sur le substrat (21).

4. Dispositif (1) selon une quelconque des revendications 1 à 3, dans lequel la première partie électroluminescente (22a) comporte une première partie luminophore (22da) comprenant un premier luminophore, et la deuxième partie électroluminescente (22b) comporte une deuxième partie luminophore (22db) comprenant un deuxième luminophore.

5. Dispositif (1) selon une quelconque des revendications 1 à 4, dans lequel la partie de commande (23) commande en outre la luminosité de la lumière émise depuis au moins une de la première partie électroluminescente(22a) et de la deuxième partie électroluminescente(22b).

6. Lampe de véhicule (100) comprenant :
le dispositif d'éclairage de véhicule (1) selon une quelconque des revendications 1 à 5 ; et
une partie d'élément optique (103) sur laquelle la lumière émise par le dispositif d'éclairage de véhicule (1) est incidente.

7. Lampe (100) selon la revendication 6, dans laquelle la partie d'élément optique (103) est un corps de guide de lumière (103a).
